# EUROPÄISCHE PATENTSCHRIFT

(11) **EP 0 333 641 B1**
(45) Veröffentlichungstag und Bekanntmachung des Hinweises auf die Patenterteilung: **18.10.1995**
(21) Anmeldenummer: 89810038.3
(22) Anmeldetag: 17.01.1989
(51) Int. Cl.: H01G 9/20

(54) **Photoelektrochemische Zelle, Verfahren zum Herstellen einer derartigen Zelle sowie Verwendung der Zelle**
Photoelectrochemical cell, process for making such a cell and use of this cell
Cellule photoélectrochimique, procédé de fabrication d'une telle cellule et utilisation de la cellule

(30) Priorität: 12.02.1988 CH 505/88
(43) Veröffentlichungstag der Anmeldung: 20.09.1989
(73) Patentinhaber: ECOLE POLYTECHNIQUE FEDERALE DE LAUSANNE (EPFL), 1015 Lausanne (CH)
(72) Erfinder: Grätzel, Michael, Prof.Dr., CH-1015 St. Sulpice (CH); Liska, Paul, CH-1018 Lausanne (CH)
(74) Vertreter: Ganguillet, Cyril

(56) Entgegenhaltungen:
- FR-A- 718 972
- REVUE PHYS. APPL., Band 16, Heft 1, Januar 1982, Seiten 5-10; N. ALONSO et al.: "Dye sensitization of ceramic semiconducting electrodes for photoelectrochemical conversion"
- J. ELECTROCHEM. SOC., Band 27, Heft 7, Juli 1980, Seiten 1475-1478; H. TI TIEN et al.: "Porphyrin modified tin oxide semiconductor as photocathode"
- JOURNAL OF THE ELECTROCHEMICAL SOCIETY, Band 134, Nr. 7, Juli 1987, Seiten 1679-1684; J. RIEFKOHL et al.: "Photoelectrochemistry with the rotating optical disk ring electrode. III. Thermal and photoinduced transfer in colloidal n- TiO2"
- PATENT ABSTRACTS OF JAPAN, Band 44, Nr. 8 (E-229)[1481], 25. Februar 1984, Seite 73 E 229; & JP-A-58 199 572
- J. ELECTROCHEM. SOC., Band 127, Nr. 1, Januar 1980, Seiten 96-98; R. SCHUMACHER et al.: "Doping density dependent attachment of RhB on TiO2 electrodes"

## Beschreibung

Die vorliegende Erfindung bezieht sich auf regenerative, photoelektrochemische Zelle, mit polykristallinem Metalloxyd-Halbleiter, mit einer weitgehend monomolekularen Chromophor-Schicht in seinem Oberflächen Bereich, ein Verfahren zum Herstellen von polykristallinen Metalloxyd-Halbleitern für derartige Zellen, sowie die Verwendung der Zellen.

In der Publikation "Dye Sensitization of Ceramic Semiconductor Electrodes" Revue Phys. Appl. 16 (1981) Seiten 5 - 10 , Alonso et al. ist die Sensibilisierung von Zinkoxid mit dem Dinonadecylderivat von Ru(bipy)₃ sowie Rhodamin B als Sensibilisatoren beschrieben. Bei dem verwendeten Zinkoxid handelt es sich dabei um ein keramisches Elektrodenmaterial. Die zur Präparation des ZnO benutzte Methode ist charakteristisch für die Herstellung keramischer Werkstoffe: ZnO Pulver wird zunächst bei hohem Druck zu einem Pressling zusammengepresst, welcher dann durch Erhitzen bei sehr hohen Temperaturen zusammengesintert wurde. Als Elektrolyt wird beispielsweise wäßriges Hydrochinon verwendet.

Es ist bekannt, dass Halbleiter/Elektrolyt-Grenzschichten photoelektrochemische Eigenschaften zeigen, die jenen der Schottky-Barriere von Halbleiter/Metall-Grenzschichten ähnlich sind. Halbleiter mit geringem Abstand zwischen Energie- und Valenzband, bei denen die Ladungsträger des Halbleiters selbst mit Licht photoelektrisch angeregt werden, wie beispielsweise bei Silizium, Gallium-Arsenid, Cadmiumsulfid, werden unter Lichtbestrahlung, bei der Verwendung von Elektrolyten photokorrosiv zersetzt.

Regenerative, photoelektrochemische Zellen mit stabilen Metalloxyd-Halbleitern zeigen eine schlechte Ausbeute bei der Bestrahlung mit Licht, insbesondere Sonnenlicht, da die Bandlücke zwischen Valenzband und Leitungsband relativ gross ist (3 eV ≈ 400 nm lambda). Die Lichtabsorption ist bei Metalloxyd-Halbleitern auf Licht im violetten und ultravioletten Bereich beschränkt. Diese Metalloxyd-Halbleiter sind weitgehend lichtdurchlässig, wären aber bei Lichtbestrahlung bei Verwendung von Elektrolyten chemisch stabil und resistent.

Die Empfindlichkeit, d.h. die photoelektrochemische Ausbeute für sichtbares Licht, also auch für Sonnenlicht, kann erhöht werden, indem auf der Oberfläche des Halbleiters sog. Chromophore, auch Sensibilisatoren oder Dyes genannt, als Ladungsträger chemisch an- oder eingelagert (chemisorbiert) werden. Die beiden Funktionen der Lichtabsorption und der Ladungsträger-Trennung sind bei diesen photoelektrochemischen Systemen getrennt. Die Lichtabsorption wird vom Chomophor im Oberflächenbereich übernommen, und die Trennung der Ladungsträger erfolgt an der Grenzschicht Halbleiter/Chromophor.

Allerdings liegt auch bei derartigen elektrochemischen Systemen mit Metalloxyd-Halbleitern mit glatter Oberfläche im Maximum des Absorptionsspektrums die Ausbeute (ERZEUGTE ELEKTRISCHE ENERGIE in Prozent der EINFALLENDEN PHOTONENENERGIE) gewöhnlich nur im Bereich von einigen wenigen Prozenten, beispielsweise im Bereich von 0.1 % bis 0.2 %.

Aufgabe der vorliegenden Erfindung ist es, eine haltbare regenerative photoelektrochemische Zelle zu schaffen, deren polykristalliner Metalloxydhalbleiter nicht korrodiert und die eine verbesserte elektrische Energie-Ausbeute im Bereich des Lichtspektrums, insbesondere des Spektrums des Sonnenlichts aufweist. Eine weitere Aufgabe der Erfindung ist es, ein Verfahren zum Herstellen von Metalloxyd-Halbleitern für derartige photoelektrochemische Systeme zu schaffen. Die Erfindung betrifft ferner die Verwendung einer photoelektrochemischen Zelle nach der Erfindung bzw. die Verwendung einer nach dem erfindungsgemässen Verfahren hergestellten Zelle.

Erfindungsgemäss ist eine derartige regenerative photoelektrochemische Zelle gekennzeichnet durch die Merkmale des Anspruches 1. Dabei weist der Metalloxyd-Halbleiter einen Rauheitsfaktor von grösser als 20, vorzugsweise grösser als 150 auf. Der Rauheitsfaktor ist definiert als das Verhältnis einer wirklichen/effektiven Oberfläche zur Fläche der Projektion dieser Oberfläche eines Körpers, in unserem Fall also der photoelektrochemisch aktiven Oberfläche des Metalloxyd-Halbleiters. Die abhängigen Ansprüche 2 bis 7 beziehen sich auf besonders vorteilhafte Ausführungen und Gruppen von Ausführungen der photoelektrochemischen Zelle.

Das erfindungsgemäße Verfahren besitzt die Merkmale des Anspruches 8.

Ein Verfahren zum Herstellen von polykristallinen Metalloxyd-Halbleiterschichten mit dem SOL-GEL-Verfahren (beschrieben in Einzelheiten z.B. in Stalder und Augustynski, J. Electrochem. Soc. 1979, 126, 2007), wo beim Verfahrensschritt der Hydrolyse des Metall-Alkoholats die prozentuale relative Feuchtigkeit der Umgebungsatmosphäre in einem Bereich von 30 % bis 80 % liegen kann und innerhalb von ±5 %, vorzugsweise ±1 %, konstant gehalten wird, ergibt Metalloxyd-Halbleiterschichten, mit denen in erfindungsgemässen photoelektrochemischen Zellen eine besonders hohe elektrochemische Ausbeute erzielt werden kann. Insbesondere kann mit einer derart, bei einer relativen Feuchte im Bereich von 48 % erzeugten Titanoxyd-Schicht ein monochromatischer Wirkungsgrad von 12 % erzielt werden, wobei der Wirkungsgrad die Leistung im optimalen Punkt in Prozent der einfallenden Lichtenergie bedeutet.

Die rauhe Oberfläche mit polykristalliner Struktur bietet eine um den Rauheitsfaktor grössere Fläche für eine monomolekulare Oberflächenschicht des Chromophors. Damit wird erreicht, dass das auf eine Fläche bestimmter Grösse einfallende Licht mit bedeutend höherer Ausbeute in elektrische Energie gewandelt wird. Der Metalloxyd-Halbleiter kann als für den einfallenden Lichtstrom durchsichtig betrachtet werden. Licht wird aber teilweise auf der Oberfläche reflektiert und gelangt z.T. auf benachbarte Oberflächen. Das in den Metalloxyd-Halbleiter eindringende Licht und nicht von der monomolekularen Chromophor-Schicht absorbierte und gewandelte Licht trifft z.T. direkt und zu einem anderen Teil indirekt, nach Totalreflexion an der Oberfläche, auf der Austrittsseite auf Chromophormoleküle, womit es gelingt, eine bedeutend höhere Lichtausbeute zu erzielen.

Verschiedene Chromophore haben unterschiedliche spektrale Empfindlichkeiten. Die Wahl des Chromophors kann somit der spektralen Zusammensetzung des Lichts der Lichtquelle angepasst werden, um die Ausbeute möglichst zu vergrössern.

Als Metalloxyd-Halbleiter sind besonders die Oxyde der Uebergangsmetalle, sowie der Elemente der dritten Hauptgruppe und der vierten, fünften und sechsten Nebengruppe (des periodischen Systems der Elemente) von Titan, Zirkon, Hafnium, Strontium, Zink, Indium, Yttrium, Lanthan, Vanadium, Niob, Tantal, Chrom, Molybdän, Wolfram, aber auch Oxyde von Zink, Eisen, Nickel oder Silber, Perovskite wie SrTiO₃, CaTiO₃ oder Oxyde von anderen Metallen der zweiten und dritten Hauptgruppe oder Mischoxyde oder Oxydgemische dieser Metalle, geeignet. Es kann aber auch jedes andere leitende Metalloxyd mit Halbleitereigenschaften und grossem Energieabstand (Bandlücke) zwischen Valenzband und Leitungband verwendet werden.

Als Chromophore, d.h.Sensibilisatoren, eignen sich beispielsweise die Komplexe von Uebergangsmetallen vom Typ Metall (L₃), Metall (L₂) von Ruthenium und Osmium (z.B. Ruthenium tris (2,2′bipyridyl-4,4′dicarboxylate), Ruthenium cis- diaqua bipyridyl Komplexe, wie Ruthenium cis-diaqua bis (2,2′bipyridyl-4,4′dicarboxylate) sowie Porphyrine (z.B. Zink tetra (4-carboxyphenyl) Porphyrin) und Cyanide (z.B. Eisen-Hexacyanid-Komplexe) und Phthalocyanine.

Die Chromophore können im Bereich der Oberfläche des Metalloxyd-Halbleiters chemisorbiert, adsorbiert oder sonstwie fest angelagert sein. Günstige Resultate wurden beispielsweise mit Chromophoren erzielt, die mit Carboxylsäure-Liganden statt Ester-Leganden an die Oberfläche des Metalloxyd-Halbleiters gebunden sind.

Als Elektrolyt für solche photoelektrochemischen Zellen sind beispielsweise Iodid, Bromid oder Hydrochinon oder andere Redox-Systeme geeignet. Diese Elektrolyten dienen aufgrund ihres Redox-Potentials als reine Relais-Substanzen für den Ladungstransport. Geeignet sind beispielsweise etwa 10⁻² M Lösungen solcher Redoxsysteme mit 1mM HClO₄ als den Ladungstransport unterstützendem Elektrolyten.

Anhand des Beispiels der Herstellung einer Titanoxydschicht (TiO₂) mit hohem Rauheitsfaktor auf einem Titansubstrat, wird nachfolgend das Sol-Gel-Verfahren beschrieben:

Das Titansubstrat aus reinem Titanium von etwa 99,5 % Reinheit wird zuerst während etwa 30 Minuten in etwa 18%iger kochender HCl gereinigt. Die Titan-Ethoxyd-Lösung kann z.B. durch die Lösung von 21 mMol TiCl₄ in 10 mL sehr reinem Ethanol (puriss.) erhalten werden. Diese Lösung wird dann mit sehr reinem Methanol (puriss.) verdünnt, um eine Titankonzentration im Bereich von etwa 25 bis 50 mg/mL zu erhalten. Auf das Titansubstrat gibt man einen Tropfen der Lösung und das Titan-Alkoxyd wird bei Raumtemperatur während ca. 30 Minuten bei einer Feuchtigkeit von 48 ± 1 % hydrolysiert. Darnach wird das Substrat mit der hydrolysierten Schicht während ca. 15 Minuten auf ca. 450°C erhitzt. Dieser Prozess wird mehrmals wiederholt. Nach 10- bis 15-maliger Wiederholung hat die TiO₂-Schicht eine Dicke von etwa 20 µ erreicht. Darnach wird das Substrat mit der Schicht bei etwa 500°C während etwa 30 Minuten in einer Rein-Argon-Atmosphäre (z.B. 99.997 %) ausgeheizt. Die so hergestellte TiO₂-Schicht hat einen Rauheitsfaktor im Bereich von 200. Derartige MetalloxyHalbleiter-Schichten (auch anderer Metalle) können nach analogen Verfahren auf anderen Substraten erzeugt werden.

Das Aufbringen des Chromophors, beispielsweise RuL₃⁴⁻, erfolgt durch Eintauchen des Substrats mit der Oxydschicht in eine wässrige Lösung von 2x10⁻⁴M RuL₃⁴⁻, die einen pH-Wert von etwa 3.5 aufweist, während etwa einer Stunde (pH-Wert angepasst mit verdünnter HCL). Andere Chromophore lassen sich nach analogen Verfahren auf Titanoxyd oder andere Metalloxyd-Halbleiter aufbringen.

Weitere Einzelheiten zur Erfindung ergeben sich aus den Zeichnungen. Es zeigen:
- Fig. 1: schematisch den Aufbau einer erfindungsgemässen photoelektrochemischen Zelle mit einer Metalloxyd-Halbleiter-Schicht deren Oberfläche chromophorbeschichtet ist;
- Fig. 2: schematisch einen Schnitt durch einen Metalloxyd-Halbleiter mit monomolekularer Chromophor-Schicht;
- Fig. 3: die Darstellung des Photostroms in Prozent des einfallenden Lichtstroms in Abhängigkeit von der Wellenlänge des Lichts für eine Titanoxyd mit RuL₃⁴⁻ als Chromophor und bei Verwendung verschiedener Elektrolyte;
- Fig. 4: die Photostrom-Spannungs-Charakteristik einer Photoelektrochemischen Zelle mit RuL₃⁴⁻-beschichtetem Titanoxyd für einfallendes Licht von 470 nm Wellenlänge.

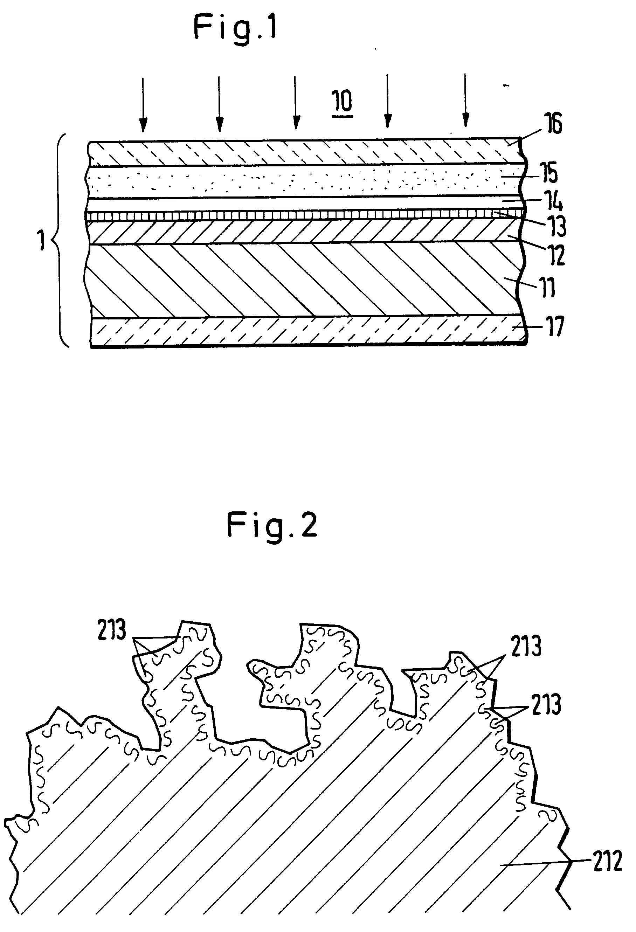

Der in Fig. 1 dargestellte Schnitt durch eine photoelektrische Zelle 1 zeigt - nicht massstäblich - einen metallischen Träger 11, auf dem eine Metalloxyd-Halbleiter-Schicht 12 aus beispielsweise Titanoxyd mit einem hohen Rauheitsfaktor von beispielsweise 200 und einer Dicke von etwa 20µ aufgebracht ist. Die monomolekulare Schicht des Sensibilisators oder Chromophors (Dye) 13 aus beispielsweise RuL₃⁴⁻ grenzt an die Elektrolytschicht 14, die auf der andern Seite an die Elektrode 15 aus beispielsweise leitendem Glas oder Kunststoff grenzt. Die Zelle 1 ist oben und unten durch je eine isolierende Schicht 16 bzw. 17 abgeschlossen. Die leitende Schicht 15 und die isolierende Schicht 16 müssen für das in elektrische Energie zu wandelnde Licht 10 durchlässig sein, sodass dieses bis zum Chromophor gelangen kann. Der hier nicht gezeigte seitliche Abschluss einer derartigen Zelle 1 kann ein Rahmen aus elektrisch isolierendem Material wie z.B. einem Kunststoff oder Glas sein.

Fig. 2 zeigt schematisch und stark vergrössert eine Metalloxyd-Halbleiterschicht 212 die einen grossen Rauheitsfaktor aufweist, mit der im Bereich der Oberfläche angeordneten monomolokularen Schicht der Chromophor-Moleküle 213. Die Diese monomokekulare Schicht kann beispielswiese aus adsorbierten, chemisorbierten Chromophor-Molekülen 213 bestehen. In die Oberflächenschicht des Metalloxyd-Halbleiters können anfänglich auch Atome oder Moleküle gedopt sein und darum herum die Chromophor-Moleküle aufgebaut werden.

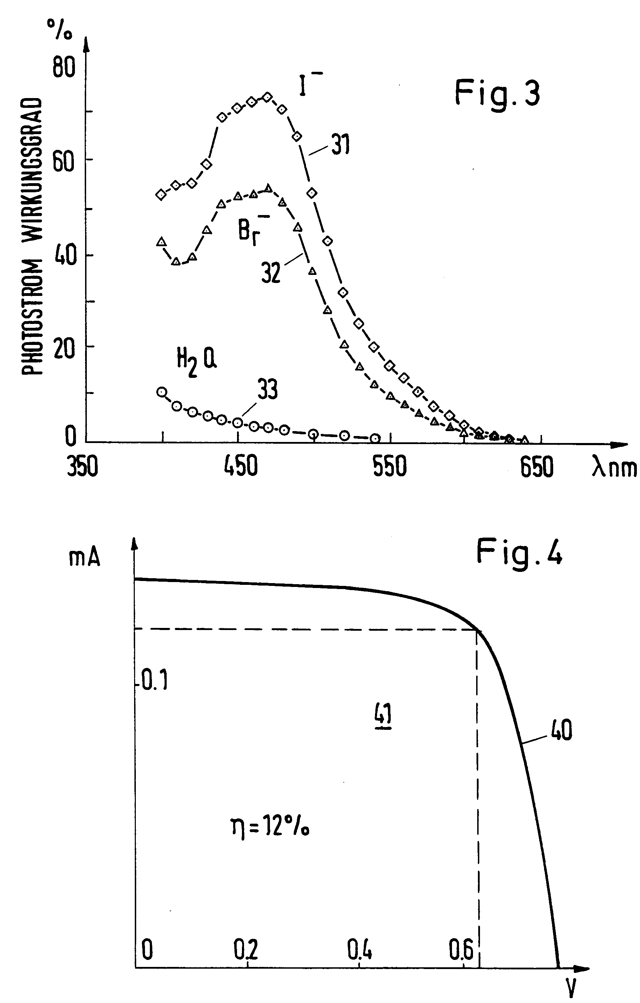

Fig. 3 zeigt zwei Diagramme des prozentualen photochemisch erzeugten Stroms einer photoelektrochemischen Zelle mit TiO₂ als Metalloxyd-Halbleiter und RuL₃⁴⁻ als Chromophor, bezogen auf den einfallenden Lichtstrom, für verschiedene Wellenlängen und für verschiedene Elektrolyten. Auf der Ordinate ist der prozentuale Photostrom-Wirkungsgrad und auf der Abszisse die Wellenlange des einfallenden Lichts in nm dargestellt. Als Basiselektrolyt wurde eine wässrige Lösung von HClO₄ (10⁻³M(molar)) als Elektronen-Donator verwendet. Bei der Messreihe, die der Kurve 31 zugrundeliegt, wurde RuL₃⁴⁻beschichtetes TiO₂ und als zusätzlicher Elektrolyt 1M KI verwendet. Bei der Messreihe der Kurve 32 wurden RuL₃⁴⁻beschichtetes TiO₂ und als zusätzlicher Elektrolyt 0.1M NaBr verwendet. Zum Vergleich ist eine Messreihe in Kurve 33 gezeigt bei der TiO₂ ohne Chromophor und als zusätzlicher Elektrolyt 10µM Hydrochinon verwendet wurden.

Fig. 4 schliesslich zeigt die Photostrom-Spannungs-Kurve 40 (-Charakteristik) einer regenerativen, photoelektrochemischen Zelle mit einem RuL₃⁴⁻beschichteten TiO₂-Metalloxyd-Halbleiter als Photoanode und einer Platin-Gegenelektrode. Auf der Ordinate ist der Strom der Zelle in Milli-Ampere und auf der Abszisse die Spannung in Volt dargestellt. Die Fläche Zelle ist 4 cm². Die auf die Zelle einfallende Licht hat eine flächenspezifische Leistung von 1.58 W/m². Die Zelle wird also mit 0.632 mW Licht bestrahlt. Der Elektrolyt enthält 10⁻³M HClO₄, 1 M LiBr und 10⁻³ M Br₂. Die Wellenlänge des erregenden Lichts ist 460 nm. Der sog. Füllfaktor 41 (dargestellt durch die Fläche des Rechtecks mit den zwei gestrichelten Seiten) beträgt 0.74 und liegt im Bereich von Zellen mit einkristallinem Silizium. (Füllfaktor der Zelle = maximale Ausgangsleistung/(Kurzschlussstrom x Spannung bei offenem Kreis)). Der monochromatische Wirkungsgrad η dieser Zelle ist 12 % und definiert als (Leistung amoptimalen Punkt x 100) / (einfallende Lichtenergie).

## Patentansprüche

1. Regenerative, photoelektrochemische Zelle (1), mit polykristallinem Metalloxyd-Halbleiter (12), mit einer weitgehend monomolekularen Chromophor-Schicht (13) in seinem Oberflächen Bereich und einem am Ladungstransport regenerativ beteiligten Elektrolyten, wobei
der Metalloxyd-Halbleiter (12) ein Metalloxyd, ein Perovskit und/oder ein Mischoxyd und/oder ein Oxydgemisch von mehreren dieser Metalloxyde ist der/das bei Lichtbestrahlung bei Verwendung des Elektrolyten chemisch stabil ist und
der/das eine rauhe Oberfläche mit polykristalliner Struktur mit einem Rauheitsfaktor von grösser als 20, vorzugsweise grösser als 150, aufweist.

2. Photoelektrochemische Zelle (1) nach Anspruch 1, dadurch gekennzeichnet, dass der Metalloxyd-Halbleiter (12) ein Oxyd eines Uebergangsmetalls oder eines Elementes der vierten, fünften oder sechsten Nebengruppe, insbesondere von Titan, Zirkon, Hafnium, Strontium, Zink, Indium, Yttrium, Lanthan, Vanadium, Niob, Tantal, Chrom, Molybdän, Wolfram, oder ein Oxyd von Zink, Eisen, Nickel oder Silber, ein Silber, ein Perovskit dieser Elemente, insbesondere SrTiO₃, CaTiO₃ und/oder ein Mischoxyd und/oder ein Oxydgemisch von mehreren dieser Metalloxyde ist.

3. Photoelektrochemische Zelle (1) nach Anspruch 1 oder 2, dadurch gekennzeichnet, dass die Chromophorschicht (13) von Übergangsmetallkomplexen gebildet wird.

4. Photoelektrochemische Zelle (1) nach Anspruch 3, dadurch gekennzeichnet, dass das Chromophor (13) ein Übergangsmetall-Komplex, vom Typ Ruthenium tris (RuL₃), Ruthenium bis (RuL₂), Osmium tris (OsL₃), Osmium bis (OsL₂), oder Ruthenium cis diaqua bipyridyl-Komplex vom Typ RuL₂(H₂O)₂, wie Ruthenium Cis.Diaqua Bis(2,2′-bipyridyl-4,4′)-dicarboxylate ist.

5. Photoelektrochemische Zelle (1) nach Anspruch 1 oder 2, dadurch gekennzeichnet, dass die Chromophorschicht (13) Phthalocyanin oder Porphyrin von Metall oder Nichtmetall ist.

6. Photoelektrochemische Zelle (1) nach einem der Ansprüche 1 bis 5, dadurch gekennzeichnet, dass die Liganden des Chromophors (13), Carboxylsäure-Liganden sind.

7. Photoelektrochemische Zelle (1) nach einem der Ansprüche 1 bis 6, dadurch gekennzeichnet, dass der Elektrolyt (14), der regenerativ am Ladungstransport beteiligt ist, Iodid, Bromid, Hydrochinon oder mehrere davon enthält.

8. Verfahren zum Herstellen einer regenerativen photoelektrochemischen Zelle nach einem der Ansprüche 1 bis 7 mit einer TiO₂-Halbleiterschicht (12) mit polykristalliner Struktur und einer rauhen Oberfläche mit einem Rauheitsfaktor von grösser als 20, bei welchem
die Halbleiterschicht auf einem metallischen Träger erzeugt wird, und
die Halbleiterschicht mit dem SOL-GEL-Verfahren aus einer Lösung TiCl₄ in reinem Ethanol, die mit reinem Methanol verdünnt ist, hergestellt wird und
beim Verfahrensschritt der Hydrolyse des Titanalkoholats, der mehrmals wiederholt wird, die prozentuale relative Feuchtigkeit der Umgebungsatmosphäre jeweils im Bereich von 30% bis 80% gehalten wird,
die hydrolydierte Schicht zwischen den Hydrolyseschritten jeweils auf eine Temperatur im Bereich von etwa 450°C erwärmt wird und
die nach den mehreren, wiederholten Schritten der Hydrolyse und des Erwärmens entstandene Schicht bei 500°C in einer Rein-Argon-Atmosphäre ausgeheizt wird.

9. Verfahren nach Anspruch 8, wo beim Verfahrensschritt der Hydrolyse des Metall- Alkoholats die prozentuale relative Feuchtigkeit der Umgebungsatmosphäre innerhalb von ±5 %, vorzugsweise ±1 %, konstant gehalten wird.

10. Verfahren nach Anspruch 8 oder 9, bei dem die Feuchtigkeit der Umgebungatmosphäre im Bereich von 48 % ± 2 %, vorzugsweise 48 % ± 1 % konstant gehalten wird.

11. Verwendung einer photoelektrochemischen Zelle (1) nach einem der Ansprüche 1 bis 7 in einer Photozelle zum Erzeugen von elektrischer Energie aus Licht (10).

12. Verwendung einer nach dem Verfahren der Ansprüche 8 bis 10 hergestellten photoelektrochemischen Zelle (1) in einer Photozelle zum Erzeugen von elektrischer Energie aus Licht (10).

13. Verwendung einer photoelektrochemischen Zelle (1) nach Anspruch 11 zum Erzeugen von elektrischer Energie aus Sonnenlicht.

14. Photozelle mit einer photoelektrochemischen Zelle (1) nach einem der Ansprüche 1 bis 7.

15. Photozelle mit einer nach dem Verfahren von einem der Ansprüche 8 bis 10 hergestellten photoelektrochemischen Zelle (1 ).

## Claims

1. Regenerative photo-electrochemical cell (1) having a polycrystalline metal oxide semiconductor (12), with a substantially monomolecular chromophore layer (13) in its surface region and an electrolyte regeneratively participating in the charge transport, wherein the metal oxide semiconductor (12) is a metal oxide, a perovskite and/or a mixed oxide and/or an oxide mixture of several of these metal oxides which is chemically stable on light irradiation when using the electrolyte and which has a rough surface with a polycrystalline structure having a roughness factor of greater than 20, preferably greater than 150.

2. Photo-electrochemical cell (1) according to claim 1, characterised in that the metal oxide semiconductor (12) is an oxide of a transition metal, or of an element of the fourth, fifth or sixth subgroup, in particular of titanium, zirconium, hafnium, strontium, zinc, indium, yttrium, lanthanum, vanadium, niobium, tantalum, chromium, molybdenum, tungsten, or an oxide of zinc, iron, nickel or silver, a perovskite of these elements in particular SrTiO₃, CaTiO₃ and/or a mixed oxide and/or an oxide mixture of a plurality of these metal oxides.

3. Photo-electrochemical cell (1) according to claim 1 or claim 2, characterised in that the chromophore layer (13) is formed by transition metal complexes.

4. Photo-electrochemical cell (1) according to claim 3, characterised in that the chromophore (13) is a transition metal complex, of the type ruthenium tris (RuL₃), ruthenium bis (RuL₂), osmium tris (OsL₃), osmium bis (OsL₂) or ruthenium cis diaqua bipyridyl complex of the type RuL₂ (H₂O)₂, such as ruthenium cis-diaqua bis (2,2′-bipyridyl-4,4′)-dicarboxylate.

5. Photo-electrochemical cell (1) according to claim 1 or claim 2, characterised in that the chromophore layer (13) is phthalocyanin or porphyrin of metal or non-metal.

6. Photo-electrochemical cell (1) according to any one of the claims 1 to 5, characterised in that the ligands of the chromophore (13) are carboxylic acid ligands.

7. Photo-electrochemical cell (1) according to any one of the claims 1 to 6, characterised in that the electrolyte (14) regeneratively participating in the charge transport contains iodide, bromide, hydroquinone or a plurality thereof.

8. Process for the manufacture of a regenerative photo-electrochemical cell in accordance with one of the claims 1 to 7, with a TiO₂ semiconductor layer (12) with polycrystalline structure and a rough surface having a roughness factor greater than 20, wherein the semiconductor layer is generated on a metallic support and the semiconductor layer is manufactured with the SOL-GEL process from a solution of TiCl₄ in pure ethanol which solution is diluted with pure methanol, and wherein, during the method step of the hydrolysis of the titanium alcoholate, which is repeated several times, the percentage relative humidity of the ambient atmosphere is in each case kept in the range from 30 % to 80 %, wherein the hydrolysed layer is in each case heated between the hydrolysis steps to a temperature in the region of about 450°C and wherein the layer which has arisen after several repeated steps of hydrolysis and heating is heated at 500°C in a pure argon atmosphere.

9. Process according to claim 8, in which the percentage relative humidity of the ambient atmosphere in the process step of the hydrolysis of the metal alcoholate is kept constant within ± 5 %, preferably within ± 1 %.

10. Process according to claim 8 or claim 9, in which the humidity of the ambient atmosphere is kept constant in the range of 48 % ± 2 %, preferably 48 % ± 1 %.

11. Use of a photo-electrochemical cell (1) according to any one of the claims 1 to 7 in a photo-cell (1) for generating electrical energy from light (10).

12. Use of a photo-electrochemical cell (1) manufactured in accordance with the process of the claims 8 to 10 in a photo-cell for generating electrical energy from light.

13. Use of a photo-electrochemical cell (1) in accordance with claim 11 for generating electrical energy from sunlight.

14. Photocell having a photo-electrochemical cell (1) in accordance with one of the claims 1 to 7.

15. Photocell having a photo-electrochemical cell (1) manufactured in accordance with the process of one of the claims 8 to 10.

## Revendications

1. Cellule photo-électrochimique (1) à régénération, avec semi-conducteur d'oxyde métallique polycristallin (12), avec une couche chromophore pratiquement monomoléculaire dans sa zone superficielle et un électrolyte participant au transport de charge par régénération, dans laquelle le semi-conducteur d'oxyde métallique (12) est un oxyde métallique, une pérovskite et/ou un oxyde mixte et/ou un mélange d'oxyde de plusieurs de ces oxydes métalliques qui sont chimiquement stables lors d'une exposition à la lumière et par utilisation d'électrolytes et qui présentent une surface rugueuse avec structure polycristalline et un facteur de rugosité supérieur à 20, de préférence supérieur à 150.

2. Cellule photo-électrochimique (1) selon la revendication 1, caractérisée en ce que le semi-conducteur d'oxyde métallique (12) est un oxyde d'un métal de transition ou d'un élément du quatrième, cinquième ou sixième sous-groupe, en particulier de titane, de zirconium, d'hafnium, de strontium, de zinc, d'indium, d'yttrium, de lanthane, de vanadium, de niobium, de tantale, de chrome, de molybdène, de tungstène, ou d'un oxyde de zinc, de fer, de nickel ou d'argent, une pérovskite de ces éléments, en particulier SrTiO₃, CaTiO₃ et/ou un oxyde mixte et/ou un mélange d'oxydes de plusieurs de ces oxydes métalliques.

3. Cellule photo-électrochimique (1) selon la revendication 1 ou 2, caractérisée en ce que la couche de chromophore (13) est formée de complexes de métaux de transition.

4. Cellule photo-électrochimique (1) selon la revendication 3, caractérisée en ce que le chromophore (13) est un complexe de métaux de transition, du type ruthénium - tris (RuL₃), ruthénium-bis (RuL₂), osmium-tris (OsL₃), osmium-bis (OsL₂), ou un complexe de cis-diaqua-bipyridyle de ruthénium du type RuL₂-(H₂O)₂, tel que cis-diaqua-bis-(2,2′-bipyridyl-4,4′)-dicarboxylate de ruthénium.

5. Cellule photo-électrochimique (1) selon la revendication 1 ou 2, caractérisée en ce que la couche de chromophore (13) est une phtalocyanine ou une porphyrine métallique ou non.

6. Cellule photo-électrochimique (1) selon l'une des revendications 1 à 5, caractérisée en ce que les ligands du chromophore (13) sont des ligands d'acides carboxyliques.

7. Cellule photo-électrochimique (1) selon l'une des revendications 1 à 6, caractérisée en ce que l'électrolyte (14), qui participe au transport de charge par régénération, contient un iodure, un bromure, de l'hydroquinone ou plusieurs de ceux-ci.

8. Procédé de fabrication d'une cellule photo-électrochimique à régénération selon l'une des revendications 1 à 7, avec une couche de semi-conducteur de TiO₂ (12) à structure polycristalline et à surface rugueuse d'un facteur de rugosité supérieur à 20, dans lequel la couche de semi-conducteur est produite sur un support métallique et la couche de semi-conducteur est réalisée par le procédé SOL-GEL à partir d'une solution de TiCl₄ dans de l'éthanol pur, qui est dilué avec du méthanol pur et, au cours de l'étape opératoire de l'hydrolyse de l'alcoolate de titane, qui est renouvelée plusieurs fois, le pourcentage d'humidité relative de l'atmosphère ambiante est maintenu entre 30 % et 80 %, la couche hydrolysée entre les étapes d'hydrolyse est portée à une température d'environ 450°C et la couche obtenue après les différentes étapes renouvelées de l'hydrolyse et de l'échauffement, est chauffée à 500 °C dans une atmosphère d'argon pur.

9. Procédé selon la revendication 8, dans lequel lors de l'étape opératoire d'hydrolyse de l'alcoolate métallique, le pourcentage d'humidité relative de l'atmosphère ambiante est maintenu constant dans la limite de ± 5 %, de préférence de ± 1 %.

10. Procédé selon la revendication 8 ou 9, dans lequel l'humidité de l'atmosphère ambiante est maintenue constante de l'ordre de 48 % ± 2 %, de préférence 48 % ± 1 %.

11. Utilisation d'une cellule photo-électrochimique (1) selon l'une des revendications 1 à 7 dans une cellule photo-électrique destinée à produire de l'énergie électrique à partir d'une lumière (10).

12. Utilisation d'une cellule photo-électrochimique (1) réalisée selon le procédé des revendications 8 à 10 dans une cellule photo-électrique destinée à produire de l'énergie électrique à partir d'une lumière (10).

13. Utilisation d'une cellule photo-électrochimique (1) selon la revendication 11 destinée à produire de l'énergie électrique à partir de la lumière solaire.

14. Cellule photo-électrique avec une cellule photo-électrochimique (1) selon l'une des revendications 1 à 7.

15. Cellule photo-électrique avec une cellule photo-électrochimique (1) réalisée selon le procédé de l'une des revendications 8 à 10.
